# EUROPÄISCHE PATENTANMELDUNG

(11) **EP 0 695 577 A2**
(43) Veröffentlichungstag der Anmeldung: **07.02.1996**
(21) Anmeldenummer: 95110179.9
(22) Anmeldetag: 29.06.1995
(51) Int. Cl.: B01J 19/12, B01J 19/18, B01J 19/20, B01J 19/08

(54) **Vorrichtung zur Plasmabehandlung von feinkörnigen Gütern**

(30) Priorität: 05.07.1994 DE 4423471
(71) Anmelder: Buck Werke GmbH & Co, D-73337 Bad Überkingen (DE)
(72) Erfinder: Bickmann, Herrmann, Dipl.-Ing., D-71254 Ditzingen (DE); Nauenburg, Klaus, Dipl.-Chem.Dr.rer.nat, D-72072 Tübingen (DE); Weichart, Jürgen, Dipl.-Phys. Dr.-Ing., D-70794 Filderstadt (DE)
(74) Vertreter: Goddar, Heinz J., Dr.

(57) **Zusammenfassung**

Vorrichtung zur Plasmabehandlung von feinkörnigen Gütern, insbesonderen Pulvern, mit einer das zu behandlende Gut aufnehmenden und dieses agitierenden, evakuierbaren Aufnahmeeinrichtung (10, 12, 14) und einer ein den Raum der Aufnahmeeinrichtung füllendes Gas zur Plasmabildung anregenden, aus einem Anregungsmittel (16) und Elektroden (18) bestehenden elektromagnetischen Einrichtung, wobei die Aufnahmeinrichtung als eine mit ein kontiniuierliches Einführen und Abführen des Guts und ein Einführen und Abführen des Prozeßgases erlaubenden Mitteln (18, 20) versehene, ansonsten hermetisch verschlossene Förderstrecke (10, 12, 14) ausgebildet ist, an oder in der die die Plasmabildung in der Förderstrecke (10, 12, 14) bewirkende elektromagnetische Anregungseinrichtung angeordnet ist.

## Beschreibung

Die Erfindung betrifft eine Vorrichtung zur Plasmabehandlung von feinkörnigen Gütern, insbesondere Pulvern, mit einer das zu behandelnde Gut aufnehmenden und dieses agitierenden Aufnahmeeinrichtung und einer ein den Raum der Aufnahmeeinrichtung füllendes Gas zur Plasmabildung anregenden, aus einem Anregungsmittel und Elektroden bestehenden elektromagnetischen Einrichtung.

Diese aus der DE 41 41 805 A1 bekannte Vorrichtung muß in "Batch-Betrieb" beschickt werden, d.h., es erfolgt ein Arbeitsablauf "Beladen - Evakuieren - Behandeln - Belüften - Entladen", was die Behandlungskapazität dieser Vorrichtung beschränkt.

Aus der US-A 4 423 303 ist ferner eine Vorrichtung bekannt, die es ermöglicht, eine größere Menge feinkörniger Güter, als die Menge, die direkt in den Behandlungsraum eingebracht werden kann, ohne eine Unterbrechung des Behandlungsvorganges zu behandeln.

Zu diesem Zweck wird zu behandelndes Gut von einem externen Vorratsbehälter zur Verfügung gestellt und bereits behandeltes Gut aus dem Behandlungsraum in einen Container überführt. Vorratsbehälter und Container sind Teil des für die Behandlung evakuierten Systems. Bei der Befüllung des Vorratsbehälters und insbesondere bei der Entleerung des Containers für das bereits behandelte Gut, muß der Behandlungsraum belüftet und somit der Behandlungsvorgang unterbrochen werden. Die dadurch zwangsweise regelmäßig auftretende Leerlaufzeit verringert den gewünschten hohen Durchsatz des zu behandelnden Guts.

Der Erfindung liegt die Aufgabe zugrunde, eine Vorrichtung zur Plasmabehandlung von feinkörnigen Gütern zu schaffen, die einen hohen Durchsatz des zu behandelnden Guts erlaubt.

Erfindungsgemäß wird diese Aufgabe dadurch gelöst, daß die Aufnahmeeinrichtung als eine mit ein kontinuierliches Einführen und Abführen des Guts und Einführen und Abführen des Plasmagases erlaubenden Mitteln versehene, ansonsten hermetisch verschlossene Förderstrecke ausgebildet ist, an oder in der die die Plasmabildung in der Förderstrecke bewirkende elektromagnetische Anregungseinrichtung angeordnet ist.

Die Förderstrecke kann dabei insbesondere als Schwingförderrinne, als Schneckenförderer oder aber als Drehrohr ausgebildet sein.

Ein bevorzugtes Ausführungsbeispiel zeichnet sich dadurch aus, daß der die Förderstrecke nach oben abdeckende Bereich aus einem dielektrischen Material besteht und die Anregungseinrichtung außerhalb der Förderstrecke durch das dielektrische Material hindurch die Plasnazündung in der Förderstrecke bewirkend ausgebildet ist.

Alternativ können die Elektroden der Anregungseinrichtung innerhalb der Förderstrecke angeordnet sein.

Die Anregung des Prozeßgases kann durch Kombination von hochfrequenter, niederfrequenter und/oder Mikrowellen-Bestrahlung erfolgen.

Weitere Merkmale und Vorteile der Erfindung ergeben sich aus der nachfolgenden Beschreibung, in der Ausführungsbeispiele anhand einer Zeichnung erläutert sind.

Dabei zeigt:
- Fig. 1: ein Ausführungsbeispiel der Erfindung bei einer Realisierung und Verwendung einer Schwingförderrinne,
- Fig. 2: eine Schnittansicht durch das in Fig. 1 gezeigte Ausführungsbeispiel,
- Fig. 3: ein Ausführungsbeispiel der Erfindung bei einer Realisierung und Verwendung eines Drehrohrs,
- Fig. 4: ein Ausführungsbeispiel der Erfindung bei einer Realisierung und Verwendung eines Schneckenförderers.

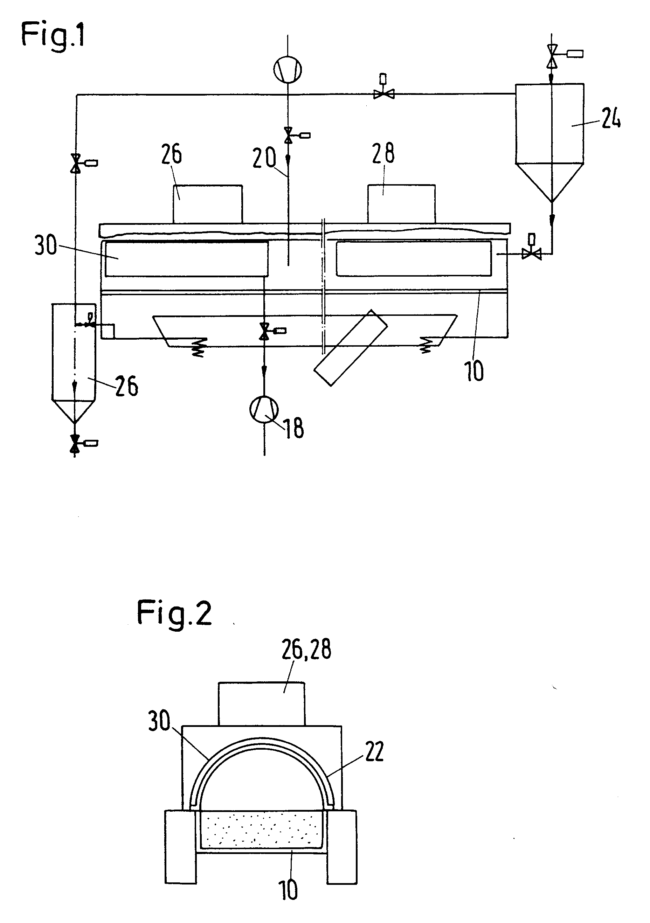

Bei dem in Fig. 1 dargestellten Ausführungsbeispiel besteht die Förderstrecke aus einer Schwingförderrinne 10, die mit einer aus einem dielektrischen Material, z.B. Quarz, Glas oder Aluminiumoxid bestehenden Kuppel 22 versehen ist. Das zu behandelnde Gut wird über eine erste Vakuumschleuse 24 in die Schwingförderrinne 10 eingebracht und in dieser in Richtung auf eine zweite Vakuumschleuse 26 hin bewegt.

Oberhalb der dielektrischen Kuppel 22 (und damit außerhalb der Schwingförderrinne 10) sind Kochfrequenzquellen 27, 28 angeordnet, die im Beispielsfall über eine Halbschalen-Elektrode 30 Energie durch die elektrische Abdeckung in die Förderrinne strahlt und dort das Plasma zündet.

Eine Vakuumeinrichtung 18 erlaubt die Evakuierung der Prozeßkammer, ein Gaseinlaß 20 die Einführung des Prozeßgases. Die Gaszufuhr und die Absaugung erfolgen über diese Einrichtungen in bekannter Weise.

Durch die in der Schwingförderrinne 10 erzeugten Mikrowürfe wird das Gut gleichzeitig bewegt, und die Flugbahn des Mediums erlaubt eine gute Umströmung von Plasma und Gas. Die am Anfang und am Ende der Schwingförderrinne angeordneten Vakuumschleusen 24, 26 erlauben einen kontinuierlichen Ablauf des Produktionsprozesses. Dabei können (bei diesem Ausführungsbeispiel nicht gezeigte) rotierende Scheiben vorgesehen sein, die die Funktionen des Füllens, Entleerens, Evakuierens und der Gaszufuhr übernehmen.

Durch ein Variieren der Schwingungen in horizontaler, vertikaler oder rotatorischer Art kann das Gut vor und zurück oder aber schneller und langsamer bewegt werden.

Die Plasmazündung kann durch eine hochfrequente Anregung aber auch durch einen niederfrequenten Wechselstromgenerator (z.B. eine kHz-Quelle) erfolgen. Die Elektrode kann sich dabei in dem Reaktor befinden und über eine flexible Leitung mit den entsprechenden Anregungsapparaturen verbunden sein. Auf diese Weise kann auch gleichzeitig Hoch- und Niederfrequenz eingespeist werden.

Die Anlagenlänge kann den örtlichen Gegebenheiten entsprechend angepaßt sein.

Eine Entleerung der Rinne kann auch durch ein Absaugen erfolgen.

Der Trocknungsprozeß kann durch eine Beheizung der Rinne unterstützt werden.

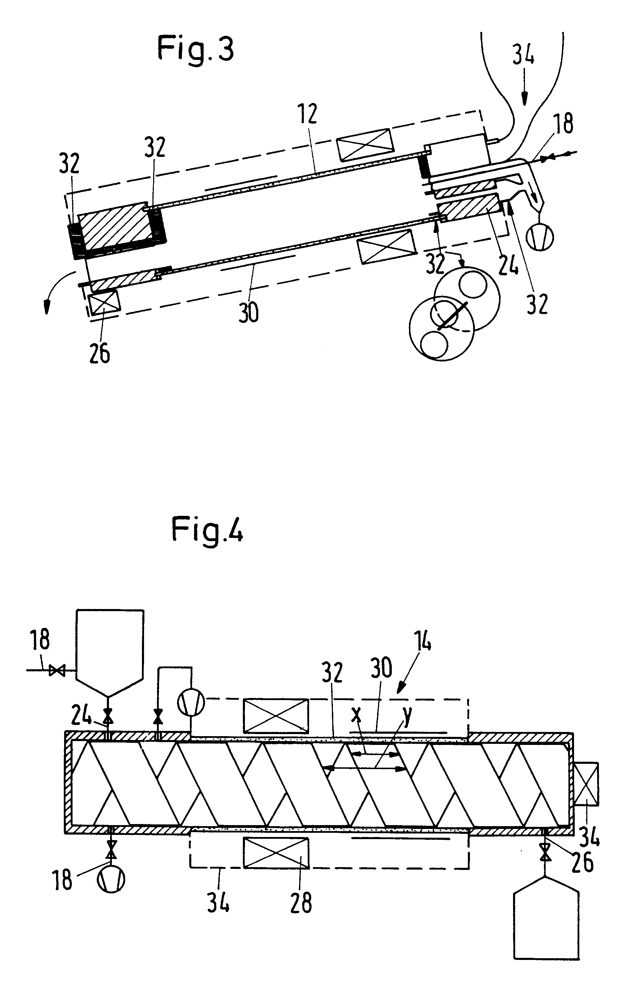

Bei dem in Fig. 3 dargestellten Ausführungsbeispiel besteht die Förderstrecke aus einem Drehrohr 12 aus einem dielektrischen Material. Dieses ist mit einer drehenden Vakuumschleuse 24 und einer drehenden, zum Ausschleusen des Behandlungsgutes dienenen weiteren Vakuumschleuse 26 versehen. Die Einfuhr des Prozeßgases erfolgt über eine entsprechende Einrichtung 18.

Das zu behandelnde Gut wird aus einem Vorratsbehälter 34 durch die Eingangsschleuse 24 in das Drehrohr eingebracht und nach Passieren des schräg angeordneten Drehrohrs 12 am gegenüberliegenden, unteren Ende abgeführt.

Hochfrequenzelektroden 30 dienen zur kapazitiven Einkopplung der das Zünden des Prozeßgases bewirkenden Energie.

Die um eine zur Förderrichtung parallel liegende Achse drehbare Vakuumschleuse 24, weist, ähnlich einer Revolvertrommel, mehrere beispielsweise sechs, Kammern, auf, die sich parallel zu der genannten Achse erstrecken und die, sowohl zur Atmosphärenseite als auch zur Vakuumseite hin, durch stationäre Scheiben oder Blenden 32 abgeschlossen sind.

Die auf der Atmosphärenseite angeordnete Scheibe weist dabei zwei kreisförmige Öffnungen auf, die eine Verbindung zu einem Vorratsbehälter 34 und einer Vakuumpumpe ermöglichen. Die auf der Vakuumseite angeordnete Scheibe weist nur eine kreisförmige Öffnung auf, die eine Verbindung zu dem Behandlungsraum innerhalb des aus einem dielektrischen Material bestehenden Drehrohres 12 ermöglicht.

Die einzelnen Kammern der Vakuumschleuse 24 sind damit entweder hermetisch abschließbar oder über eine der kreisförmigen Öffnungen der Scheiben 32 zum Vorratsbehälter 34, zu einer Vakuumpumpe oder zum Behandlungsraum hin zu öffnen.

Zum Befüllen wird nun eine der Kammern in eine Position gebracht, daß diese zum Vorratsbehälter 34 hin geöffnet ist. Dabei wird sie mit Schüttgut aufgefüllt. Beim Drehen der Schleusenkammer 24 wird diese Kammer, zumindest kurzfristig, durch die beiden Scheiben 32 hermetisch abgeriegelt. Durch ein weiteres Drehen, beispielsweise um 60°, öffnet sich diese Kammer zu einem Pumpflansch hin und der Gasraum in der Kammer um das Schüttgut herum wird evakuiert. Durch ein erneutes Drehen der Schleuse 24 wird die Kammer wieder hermetisch abgeriegelt und öffnet sich dann zu dem Behandlungsraum hin, so daß das Schüttgut, ohne einen Druckanstieg in dem Behandlungsraum zu verursachen, in diesen eingeschleust wird.

Die Schleuse wird weiterhin gedreht, dadurch hermetisch abgeriegelt und öffnet sich schließlich erneut zu dem Vorratsbehälter 34 hin, so daß der bisher beschriebene Vorgang wieder beginnt.

In der "Revolverschleuse" sind mehrere solche Kammern vorgesehen, deren Anzahl und Größe den entsprechenden Erfordernissen angepaßt werden kann. Somit wird ein kontinuierliches Befüllen des Behandlungsraumes ermöglicht, wobei insbesondere keine Unterbrechungen der Behandlung notwending sind, um den Vorratsbehälter 34 aufzufüllen.

Das Ausschleusen des Stückgutes aus dem Behandlungsraum erfolgt durch eine entsprechend aufgebaute Schleuse 26. Der Behandlungsraum 12 befindet sich immer in einem evakuierten Zustand.

Die Zufuhr des Prozeßgases erfolgt kontinuierlich über eine entsprechende Einrichtung 18. Sie kann aber auch über die einzelnen Kammern der Vakuumschleuse 24 erfolgen. In diesem Fall weist die auf der Atmosphärenseite angeordnete Scheibe eine zusätzliche dritte Öffnung auf, durch die das Prozeßgas in die Kammern der Vakuumschleuse nach dem Evakuieren und vor dem Öffnen der Kammern zum Behandlungsraum hin eingeführt wird.

Bei dem in Fig. 4 dargestellten Ausführungsbeispiel ist die Förderstrecke als Schneckenförderer 14 ausgebildet, wobei die Höhe des Schneckensteges mit x und die Steghöhe der Schnecke mit y angegeben ist. Die Schnecke wird über einen Schneckenantrieb 34 angetrieben.

Das Rohr 32 des Schneckenförderers besteht wiederum aus dielektrischem Material. Unterhalb des Rohres sind eine Abschirmung und ein Träger 34 für die Einrichtung 28 zur Erzeugung von Mikrowellen angeordnet.

Das zu behandelnde Gut wird wieder über eine Vakuumschleuse 24 eingeführt und über eine Vakuumschleuse 26 wieder aus dem Schneckenförderer 14 abgeführt. Eine Vakuumpumpe 18 erlaubt ein Evakuieren der Prozeßkammer.

Hochfrequenzelektroden 30 sind um den Schneckenförderer angeordnet. Das Prozeßgas wird über eine Zuleitung 18 durch die Einsatzschleuse 24 hindurch in den Schneckenförderer eingebracht. Der Zulauf des Schüttgutes erfolgt nur während einer durch die Schneckengeometrie gegebenen Zeit x/y. Die Schnecke fördert das Schüttgut in dem Rohr 32, während Mikrowellenenergie von außen durch die Wandung des Rohres in dieses hineingeführt wird. Alternativ (oder aber auch additiv) kann auch Hochfrequenz von außen durch Kombination von Quarzglasabschnitten, an denen abwechselnd Radiofrequenz (z.B. 13,56 Mhz) und Mikrowellenenergie eingespeist wird, zugeführt werden.

Alternativ kann die Schnecke jedoch auch an der Innenwandung des Rohres eingebracht sein, wobei dann ein Gigatron zur Mikrowelleneinkopplung und/oder eine Elektrode auf der Mittelachse des Rohres angeordnet sind (dieses Ausführungsbeispiel ist zeichnerisch nicht dargestellt). Auch kann das Magnetron von einer Seite und kann die Elektrode von der anderen Seite eingeführt werden. Weitere Variationen, bei denen am Rohrmantel Fenster angebracht sind, durch die die Mikrowelle oder Radiofrequenz eingespeist werden, sind möglich.

Die in den Ansprüchen, der Beschreibung und in den beiliegenden Zeichnungen dargestellten Ausführungsbeispiele der Erfindung sind lediglich beispielhaft und beschränken den sich allein aus den Ansprüchen ergebenden Schutzbereich der Erfindung in keiner Weise.

## Patentansprüche

1. Vorrichtung zur Plasmabehandlung von feinkörnigen Gütern, insbesonderen Pulvern, mit einer das zu behandlende Gut aufnehmenden und dieses agitierenden, evakuierbaren Aufnahmeeinrichtung (10, 12, 14) und einer ein den Raum der Aufnahmeeinrichtung füllendes Gas zur Plasmabildung anregenden, aus einem Anregungsmittel (16) und Elektroden (18) bestehenden elektromagnetischen Einrichtung,
dadurch gekennzeichnet, daß
die Aufnahmeinrichtung als eine mit ein kontiniuierliches Einführen und Abführen des Guts und ein Einführen und Abführen des Prozeßgases erlaubenden Mitteln (18, 20) versehene, ansonsten hermetisch verschlossene Förderstrecke (10, 12, 14) ausgebildet ist, an oder in der die die Plasmabildung in der Förderstrecke (10, 12, 14) bewirkende elektromagnetische Anregungseinrichtung angeordnet ist.

2. Vorrichtung nach Anspruch 1, dadurch gekennzeichnet, daß die Förderstrecke als Schwingförderer (10) ausgebildet ist.

3. Vorrichtung nach Anspruch 1, dadurch gekennzeichnet, daß die Förderstrecke als Drehrohr (12) ausgebildet ist.

4. Vorrichtung nach Anspruch 1, dadurch gekennzeichnet, daß die Förderstrecke als Schneckenförderer (14) ausgebildet ist.

5. Vorrichtung nach einem der vorangehenden Ansprüche, dadurch gekennzeichnet, daß der die Förderstrecke (10, 12, 14) nach oben oder rundum abdeckende Bereich aus einem dielektrischen Material besteht und die Anregungseinrichtung außerhalb der Förderstrecke (10, 12, 14) durch das dielektrische Material hindurch die Plasmazündung in der Förderstrecke (10, 12, 14) bewirkend ausgebildet ist.

6. Vorrichtung nach einem der Ansprüche 1 bis 4, dadurch gekennzeichnet, daß die Elektroden (18) der Anregungseinrichtung innerhalb der Förderstrecke (10, 12, 14) angeordnet sind.

7. Vorrichtung nach einem der Ansprüche 1 bis 4, dadurch gekennzeichnet, daß die Anregung des Prozeßgases durch Kombination von hochfrequenter (z.B. 13,56 Mhz), niederfrequenter (im kHz-Bereich) und/oder Mikrowellen-Bestrahlung erfolgt.
